# EUROPEAN PATENT SPECIFICATION

(11) **EP 0 727 712 B1**
(45) Date of publication and mention of the grant of the patent: **27.10.1999**
(21) Application number: 96200293.7
(22) Date of filing: 10.02.1996
(51) Int. Cl.: G03F 7/07

(54) **Integral silver halide diffusion transfer lithographic printing plates**
Lithographische Druckplatten nach dem Silbersalzdiffusions-Übertragungsverfahren
Plaques d'impression lithographiques selon le procédé de diffusion transfert de sel d'argent

(30) Priority: 14.02.1995 US 388707
(43) Date of publication of application: 21.08.1996
(73) Proprietor: EASTMAN KODAK COMPANY, Rochester, New York 14650-2201 (US)
(72) Inventor: Gingello, Anthony D., c/o Eastman Kodak Co., Rochester, New York 14650-2201 (US); Harris, Mark A., c/o Eastman Kodak Co., Rochester, New York 14650-2201 (US); Bowman, Wayne A., c/o Eastman Kodak Co., Rochester, New York 14650-2201 (US)
(74) Representative: Nunney, Ronald Frederick Adolphe

(56) References cited:
- EP-A- 0 394 874
- FR-A- 2 338 514
- JP-A- 5 241 343
- US-A- 5 236 802

## Description

### FIELD OF THE INVENTION

This invention relates in general to lithographic printing plates and in particular to lithographic printing plates which utilize the silver salt diffusion transfer process. More specifically, this invention relates to single-sheet lithographic printing plates which utilize the silver salt diffusion transfer process and are commonly referred to as integral diffusion transfer plates.

### BACKGROUND OF THE INVENTION

Integral silver halide diffusion transfer lithographic printing plates are well known and have been widely used for many years. These plates are comprised of a support, such as, for example, a sheet of a dimensionally-stable polymeric film, which typically has a backing layer on one side thereof and, in order, on the opposite side an underlayer, an image-forming layer and an image-receiving layer.

Detailed descriptions of integral silver halide diffusion transfer lithographic printing plates and the process in which they are employed are provided by Schultze, "Graphic Arts Applications of Silver Difusion Transfer Systems", Journal of Applied Photographic Engineering, Vol. 5, No. 3, pages 163-166 (1979) and by Poot and DeJaeger, "A Camera Speed Diffusion Transfer Offset Master on Filmbase", Journal of Applied Photographic Engineering, Vol. 5, No. 3, pages 169-171 (1979).

In integral silver halide diffusion transfer lithographic printing plates, the image-forming layer is a light-sensitive silver halide emulsion layer and the image-receiving layer is a layer that contains physical development nuclei. The printing plate is imagewise-exposed to actinic radiation and then processed with a suitable activator solution or developing solution. Processing takes place in the presence of both a developing agent and a silver halide solvent. The developing agent can be incorporated in one of the layers of the printing plate, most typically the underlayer, and when this is done processing can be carried out with an aqueous alkaline activator solution that need not contain a developing agent. When no developing agent is incorporated in the underlayer, or other layer of the printing plate, then processing is carried out with an aqueous alkaline developing solution that contains one or more developing agents. The silver halide solvent is preferably incorporated in the activator solution, or developing solution, but can, if desired, be incorporated in one of the layers of the printing plate. An antihalation agent is also employed to prevent undesired spreading of the image which is known as halation. The antihalation agent is most usually incorporated in the underlayer but can, if desired, be incorporated in the support or in a backing layer.

The latent image formed in the silver halide emulsion layer by imagewise exposure is converted to silver in the processing step and simultaneously the silver halide in the unexposed areas is converted to a silver halide complex which diffuses into the image-receiving layer. The physical development nuclei in the image-receiving layer serve as sites for precipitation of the silver halide complex as a silver image. Treatment with a conditioning solution renders the silver image receptive to printing inks and the resulting lithographic printing plate is mounted on the printing press and used to make prints, typically in press runs producing up to about twenty thousand copies.

The ability of integral silver halide diffusion transfer lithographic printing plates to meet the dual objectives of long press run length and high print quality is dependent on the composition of the image-forming layer and image-receiving layer and on the complex interactions that take place between these layers in the course of the process. It is particularly critical that a dense and durable silver image of appropriate morphology is formed at the upper surface of the image-receiving layer.

It is toward the objective of providing an improved integral silver halide diffusion transfer lithographic printing plate, that is capable of providing both good image quality and an extended press run, that the present invention is directed.

### SUMMARY OF THE INVENTION

In accordance with this invention, an integral silver halide diffusion transfer lithographic printing plate is comprised of a support having, in order, on one side thereof:
(1) an image-forming layer comprising a film-forming binder and silver halide grains; and
(2) an image-receiving layer comprising a film-forming binder, physical development nuclei, and a polymer having epoxy functionality that enhances the wear-resistance of the image-receiving layer.

In a preferred embodiment of the invention, the image-receiving layer additionally includes both a polyalkoxysilane and a polymer having hydroxy, carboxy or carbonyl functional groups.

In another preferred embodiment of the invention, the silver halide grains employed in the image-forming layer are fine-grain silver halide grains having a mean grain size of less than 0.5 micrometers.

In a still further preferred embodiment of the invention, the printing plate additionally includes an underlayer interposed between the support and the image-forming layer. The underlayer comprises a developing agent or an antihalation agent or both a developing agent and an antihalation agent dispersed in a film-forming binder.

The durability of the silver image that is formed in the image-receiving layer and, consequently, the number of high quality impressions that can be obtained with the printing plate is dependent on many factors, among the most important of which are the stability of the silver halide complex, the rate at which the complex diffuses, the rate at which the complex is reduced to metallic silver, and the size and shape of the silver particles that are formed.

The use of fine-grain silver halide grains, that is, grains having a mean grain size of less than 0.5 micrometers, in the image-forming layer, is highly preferred in the present invention. Such grains are rapidly solubilized to form a silver halide complex and are able to diffuse rapidly into the image-receiving layer and precipitate on the physical development nuclei to form a robust silver layer which exhibits excellent printing characteristics. Preferably the silver halide grains have a mean grain size of less than 0.4 micrometers and most preferably of 0.3 micrometers.

The use of a polymer having epoxy functionality, as hereinafter described in detail, has been unexpectedly found to provide excellent wear characteristics that permit extended press runs. Still further improvement in the length of the press run can be achieved by including in the image-receiving layer, in addition to the polymer having epoxy functionality, both a polyalkoxysilane and a polymer having hydroxy, carboxy or carbonyl functional groups.

The exact mechanisms whereby the invention functions are not understood. The polymer having epoxy functionality is believed to take part in cross-linking reactions. The polyalkoxysilane is believed to be hydrolyzed and the product of hydrolysis may interact with the polymer having hydroxy, carboxy or carbonyl groups. The epoxide group of the polymer having epoxy functionality is known to be capable of reacting with hydroxyl groups so all three polymers may interact to form a crosslinked network that provides both excellent adhesion and excellent abrasion-resistance. It is likely that a hydrogen bonding mechanism is involved in the formation of the network.

In the present invention, it is particularly preferred that the developing agent or combination of developing agents is incorporated in an underlayer and that processing is carried out with an activator solution that contains no developing agent. It is also particularly preferred that an antihalation agent is incorporated in the underlayer along with the developing agent(s) and that the silver halide solvent is incorporated in the activator solution.

The printing plates of this invention are useful for both camera and laser-exposure applications and serve as low-cost dimensionally-stable plates that are especially well adapted for short to medium run color applications.

### DESCRIPTION OF THE PREFERRED EMBODIMENTS

The integral silver halide diffusion transfer lithographic printing plates of this invention can utilize any of the polymeric film supports known for use in the photographic arts. Typical of useful polymeric film supports are films of cellulose nitrate and cellulose esters such as cellulose triacetate and diacetate, polystyrene, polyamides, homo- and co-polymers of vinyl chloride, poly(vinylacetal), polycarbonate, homo- and co-polymers of olefins, such as polyethylene and polypropylene and polyesters of dibasic aromatic carboxylic acids with divalent alcohols, such as poly(ethylene terephthalate).

Polyester films, such as films of poly(ethylene terephthalate), have many advantageous properties, such as excellent strength and dimensional stability, which render them especially advantageous for use as supports in the present invention.

The polyester film supports which can be advantageously employed in this invention are well known and widely used materials. Such film supports are typically prepared from high molecular weight polyesters derived by condensing a dihydric alcohol with a dibasic saturated fatty carboxylic acid or derivatives thereof. Suitable dihydric alcohols for use in preparing polyesters are well known in the art and include any glycol, wherein the hydroxyl groups are on the terminal carbon atoms and which contains from 2 to 12 carbon atoms such as, for example, ethylene glycol, propylene glycol, trimethylene glycol, hexamethylene glycol, decamethylene glycol, dodecamethylene glycol, and 1,4-cyclohexane dimethanol. Dibasic acids that can be employed in preparing polyesters are well known in the art and include those dibasic acids containing from 2 to 16 carbon atoms. Specific examples of suitable dibasic acids include adipic acid, sebacic acid, isophthalic acid, and terephthalic acid. The alkyl esters of the above-enumerated acids can also be employed satisfactorily. Other suitable dihydric alcohols and dibasic acids that can be employed in preparing polyesters from which sheeting can be prepared are described in J. W. Wellman, U.S. Patent No. 2,720,503, issued October 11, 1955.

Specific preferred examples of polyester resins which, in the form of sheeting, can be used in this invention are poly(ethylene terephthalate), poly(cyclohexane 1,4-dimethylene terephthalate), and the polyester derived by reacting 0.83 mol of dimethyl terephthalate, 0.17 mol of dimethyl isophthalate and at least one mol of 1,4-cyclohexanedimethanol. U.S. Patent No. 2,901,466 discloses polyesters prepared from 1,4-cyclohexanedimethanol and their method of preparation.

The thickness of the polyester sheet material employed in carrying out this invention is not critical. For example, polyester sheeting of a thickness of from 0.05 to 0.25 millimeters can be employed with satisfactory results.

In a typical process for the manufacture of a polyester photographic film support, the polyester is melt extruded through a slit die, quenched to the amorphous state, oriented by transverse and longitudinal stretching, and heat set under dimensional restraint. In addition to being directionally oriented and heat set, the polyester film can also be subjected to a subsequent heat relax treatment to provide still further improvement in dimensional stability and surface smoothness.

The image-forming layer utilized in this invention is comprised of a silver halide emulsion and typically contains suitable sensitizing dyes and antifoggants.

The useful silver halide emulsions for use in this invention include silver chloride, silver bromide, silver chlorobromide, silver bromoiodide, silver chloroiodide and silver chlorobromoiodide emulsions. Preferably the emulsions are high chloride emulsions in which the silver halide grains are at least 80 mole percent chloride. Most preferably, the emulsions are one hundred percent silver chloride.

It is a preferred feature of this invention that the silver halide grains have a mean grain size of less than 0.5 micrometers, more preferably of less than 0.4 micrometers and most preferably of 0.3 micrometers. Methods for determining the mean grain size of silver halide grains are well known in the photographic art. They are described, for example, in James, The Theory of the Photographic Process, 4th Ed., pages 100 to 102, MacMillan Publishing Co. (1977).

The silver halide emulsions utilized in this invention preferably employ silver halide grains in which a doping agent has been incorporated to control the speed and contrast. Such use of doping agents is very well known in the photographic art. The doping agents are typically added during the crystal growth stages of emulsion preparation, for example, during initial precipitation and/or physical ripening of the silver halide grains. Rhodium is a particularly well known doping agent, and can be readily incorporated in the grains by use of suitable salts such as rhodium trichloride. Other particularly useful doping agents include iridium, ruthenium, rhenium, chromium and osmium.

McDugle et al U.S. Patent 4,933,272, issued June 12, 1990, discloses silver halide emulsions comprised of radiation-sensitive silver halide grains exhibiting a face centered cubic crystal lattice structure internally containing a nitrosyl or thionitrosyl coordination ligand and a transition metal chosen from groups 5 to 10 inclusive of the periodic table of elements. These emulsions are preferred for use in the integral silver halide diffusion transfer lithographic printing plates of this invention.

In accordance with the aforesaid U.S. Patent 4,933,272, the dopants located within the silver halide grains are transition metal coordination complexes which contain one or more nitrosyl or thionitrosyl ligands. These ligands have the formula: 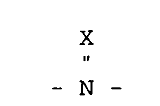 where X is oxygen in the case of nitrosyl ligands and sulfur in the case of thionitrosyl ligands.

Preferred dopants utilized in this invention are transition metal coordination complexes having the formula:

[M(NX)(L)₅]ₙ

wherein:
M is a ruthenium, rhenium, chromium, osmium or iridium transition metal;
X is oxygen or sulfur;
L is a ligand; and
n is -1, -2, or -3.

As in the aforesaid U.S. Patent 4,933,272, all references herein to periods and groups within the periodic table of elements are based on the format of the periodic table adopted by the American Chemical Society and published in the Chemical and Engineering News, Feb. 4, 1985, p. 26. In this form the prior numbering of the periods was retained, but the Roman numeral numbering of groups and designations of A and B groups (having opposite meanings in the U.S. and Europe) was replaced by a simple left to right 1 through 18 numbering of the groups.

In addition to the doped silver halide grains, the silver halide emulsions employed in this invention also contain a film-forming binder that serves as a vehicle. The proportion of binder can be widely varied, but typically is within the range of from 20 to 250 g/mole silver halide.

Most commonly, the film-forming binder used in silver halide emulsions is a hydrophilic colloid. The hydrophilic colloid is preferably gelatin, but many other suitable hydrophilic colloids are also known to the photograpic art and can be used alone or in combination with gelatin. Suitable hydrophilic colloids include naturally occurring substances such as proteins, protein derivatives, cellulose derivatives --e.g., cellulose esters, gelatin -- e.g., alkali-treated gelatin (cattle bone or hide gelatin) or acid-treated gelatin (pigskin gelatin), gelatin derivatives -- e.g., acetylated gelatin, and phthalated gelatin, polysaccharides such as dextran, gum arabic, zein, casein, pectin, collagen derivatives, collodion, agar-agar, arrowroot, and albumin.

In addition to the hydrophilic colloid and the silver halide grains, the radiation-sensitive silver halide emulsion layers employed in this invention can include a polymer latex which serves to improve the dimensional stability of the printing plate. Polymers usable in latex form for this purpose are very well known in the photographic art. The requirements for such a polymer latex are (1) that it not interact with the hydrophilic colloid such that normal coating of the emulsion layer is not possible, (2) that it have optical properties, i.e., refractive index, similar to that of the hydrophilic colloid, and (3) that it have a glass transition temperature such that it is plastic at room temperature. Preferably, the glass transition temperature is below 20°C.

The polymer latex useful in the present invention is an aqueous dispersion of a water-insoluble polymer. It is incorporated in an emulsion layer in an amount that is typically in the range of from 0.2 to 1.5 parts per part by weight of the hydrophilic colloid.

The synthetic polymeric latex materials referred to herein are generally polymeric materials which are relatively insoluble in water compared to water-soluble polymers, but have sufficient water solubility to form colloidal suspensions of small polymeric micelles. Typical latex polymeric materials can be made by rapid copolymerization with vigorous agitation in a liquid carrier of at least one monomer which would form a hydrophobic homopolymer. In certain preferred embodiments, from about 1 to about 30 percent, by weight, of units of monomer containing the water-solubilizing group is present in the copolymer product. Copolymers prepared by this method and analogous methods provide discrete micelles of the copolymer which have low viscosities in aqueous suspensions. Typical useful copolymers include interpolymers of acrylic esters and sulfoesters as disclosed in Dykstra, U.S. Patent 3,411,911, issued November 19, 1968, interpolymers of acrylic esters and sulfobetains as described in Dykstra and Whiteley, U.S. Patent No. 3,411,912, issued November 19, 1968, interpolymers of alkyl acrylates and acrylic acids as disclosed in Ream and Fowler, U.S. Patent No. 3,287,289, issued November 22, 1966, interpolymers of vinyl acetate, alkyl acrylates and acrylic acids as disclosed in Corey, U.S. Patent No. 3,296,169, and interpolymers as disclosed in Smith, U.S. Patent No. 3,459,790, issued August 5, 1969. Polymeric latex materials can also be made by rapid polymerization with vigorous agitation of hydrophobic polymers when polymerized in the presence of high concentrations of surfactants which contain water-solubilizing groups. The surfactants are apparently entrained in the micelle and the solubilizing group of the surfactant provides sufficient compatibility with aqueous liquids to provide a dispersion very much like a soap. Generally good latex materials are also disclosed in Nottorf, U.S. Patent No. 3,142, 568, issued July 28, 1964; White, U.S. Patent No. 3,193,386, issued July 6, 1965; Houck et al, U.S. Patent No. 3,062,674, issued November 6, 1962; and Houck et al, U.S. Patent No. 3,220,844, issued November 30, 1965.

The synthetic polymeric latex materials are generally polymerized in a manner to produce micelles of about 1.0 micron average diameter or smaller to be highly useful in photographic emulsions and preferably the discrete micelles are less than 0.3 micron in average diameter. Generally, the micelles can be observed by photomicrographs when incorporated in gelatino emulsions, however, it is understood that some coalescing can occur when the emulsions are coated and dried.

In one embodiment, the latex polymers which can be used according to this invention are acrylic interpolymers, i.e., those interpolymers prepared from polymerizable acrylic monomers containing the characteristic acrylic group

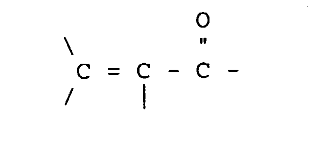

Such polymers are conveniently prepared by the interpolymerization of an acrylic monomer with at least one dissimilar monomer which can be another acrylic monomer or some other different polymerizable ethylenically unsaturated monomer. It is, of course, understood that the acrylic interpolymers employed in the practice of this invention are compatible with gelatin and have a Tg (glass transition temperature) of less than 20°C. (Tg can be calculated by differential thermal analysis as disclosed in "Techniques and Methods of Polymer Evaluation", Vol. 1, Marcel Dekker, Inc., N.Y., 1966).

A particularly preferred polymer latex for use in a silver halide emulsion layer is poly(methylacrylate-co-2-acrylamido-2-methyl propane sulfonic acid) which is comprised of repeating units of the formula:

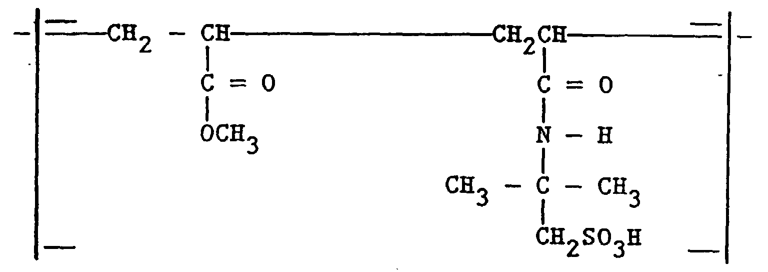

The underlayer which is utilized in a preferred embodiment of this invention is comprised of a film-forming binder and can contain one or more developing agents. Useful film-forming binders include those described hereinabove with reference to the image-forming layer. Preferably, the binder is a hydrophilic colloid and most preferably it is gelatin. If desired, a polymer latex can be used in combination with the hydrophilic colloid. The primary developing agent is commonly a dihydroxybenzene developing agent and it is preferably employed in combination with an auxiliary super-additive developing agent.

The dihydroxybenzene developing agents employed in this invention are well known and widely used in photographic processing. The preferred developing agent of this class is hydroquinone. Other useful dihydroxybenzene developing agents include:
chlorohydroquinone,
bromohydroquinone,
isopropylhydroquinone,
toluhydroquinone,
2,3-dichlorohydroquinone,
2,5-dimethylhydroquinone,
2,3-dibromohydroquinone,
1,4-dihydroxy-2-acetophenone-2,5-dimethylhydroquinone,
2,5-diethylhydroquinone,
2,5-di-p-phenethylhydroquinone,
2,5-dibenzoylaminohydroquinone, and
2,5-diacetaminohydroquinone.

The auxiliary super-additive developing agents employed in this invention are also well known and widely used in photographic processing. As explained in Mason, "Photographic Processing Chemistry", Focal Press, London, 1975, "superadditivity" refers to a synergistic effect whereby the combined activity of a mixture of two developing agents is greater than the sum of the two activities when each agent is used alone in the same developing solution (Note especially the paragraph entitled, "Superadditivity" on Page 29 of Mason).

For the purposes of this invention, the preferred auxiliary super-additive developing agents are the 3-pyrazolidone developing agents. Particularly preferred developing agents of this class are those represented by the formula: 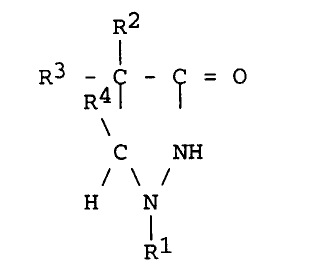 in which R¹ is aryl (including substituted aryl) and R², R³, and R⁴ are hydrogen or alkyl (including substituted alkyl). Included within the definition of R¹ are phenyl and phenyl substituted with groups such as methyl, chloro, amino, methylamino, acetylamino, methoxy and methylsulfonamidoethyl. Included within the definition of R², R³ and R⁴ are unsubstituted alkyl and alkyl substituted with groups such as hydroxy, carboxy, or sulfo. The most commonly used developing agents of this class are 1-phenyl-3-pyrazolidone, 1-phenyl-4,4-dimethyl-3-pyrazolidone, 1-phenyl-4-methyl-4-hydroxymethyl-3-pyrazolidone and 1-phenyl-4,4-dihydroxymethyl-3-pyrazolidone. Other useful 3-pyrazolidone developing agents include:
1-phenyl-5-methyl-3-pyrazolidone,
1-phenyl-4,4-diethyl-3-pyrazolidone,
1-p-aminophenyl-4-methyl-4-propyl-3-pyrazolidone,
1-p-chlorophenyl-4-methyl-4-ethyl-3-pyrazolidone,
1-p-acetamidophenyl-4,4-diethyl-3-pyrazolidone,
1-p-betahydroxyethylphenyl-4,4-dimethyl-3-pyrazolidone,
1-p-hydroxyphenyl-4,4-dimethyl-3-pyrazolidone,
1-p-methoxyphenyl-4,4-diethyl-3-pyrazolidone, and
1-p-tolyl-4,4-dimethyl-3-pyrazolidone.

Less preferred but also useful auxiliary super-additive developing agents for use in this invention are aminophenols. Examples of useful aminophenols include:
p-aminophenol
o-aminophenol
N-methylaminophenol
2,4-diaminophenol hydrochloride
N-(4-hydroxyphenyl)glycine
p-benzylaminophenol hydrochloride
2,4-diamino-6-methylphenol
2,4-diaminoresorcinol, and
N-(beta-hydroxyethyl)-p-aminophenol.

In addition to one or more developing agents, a sulfite preservative can also be included in the underlayer. By the term "sulfite preservative" as used herein is meant any sulfur compound that is capable of forming sulfite ions in aqueous alkaline solution. Examples of such compounds include alkali metal sulfites, alkali metal bisulfites, alkali metal metabisulfites, sulfurous acid and carbonyl-bisulfite adducts.

Examples of preferred sulfites for use in this invention include sodium sulfite (Na₂SO₃), potassium sulfite (K₂SO₃), lithium sulfite (Li₂SO₃), sodium bisulfite (NaHSO₃), potassium bisulfite (KHSO₃), lithium bisulfite (LiHSO₃), sodium metabisulfite (Na₂S₂O₅), potassium metabisulfite (K₂S₂O₅), and lithium metabisulfite (Li₂S₂O₅).

The carbonyl-bisulfite adducts which are useful in this invention are well-known compounds. Adducts of adehydes and adducts of ketones are useful and the adlehydes employed can be monoaldehydes, dialdehydes or trialdehydes and the ketones can be monoketones, diketones or triketones. The bisulfite adducts can be adducts of alkali metal bisulfites, alkaline earth metal bisulfites or nitrogen-base bisulfites such as amine bisulfites.

Illustrative examples of the many carbonyl-bisulfite adducts which are useful in the present invention include the following compounds (all of those listed being sodium bisulfite adducts for the purpose of convenience in illustrating the invention but it being understood that the compounds can also be employed in the form of adducts of other suitable bisulfites as explained hereinabove):
sodium formaldehyde bisulfite
sodium acetaldehyde bisulfite
sodium propionaldehyde bisulfite
sodium butyraldehyde bisulfite
succinaldehyde bis-sodium bisulfite
glutaraldehyde bis-sodium bisulfite
beta-methyl glutaraldehyde bis-sodium bisulfite
maleic dialdehyde bis-sodium bisulfite
sodium acetone bisulfite
sodium butanone bisulfite
sodium pentanone bisulfite, and
2,4-pentadione bis-sodium bisulfite.

It is particularly preferred to include an antihalation agent in the underlayer of the integral diffusion transfer printing plates of this invention. Useful antihalation agents are described in U.S. Patent No. 3,201,249 and include pigments, dyes and mixtures thereof. Examples of suitable dyes or pigments include hydroxyazaindolizines, xanthylium salts, pyrylium salts, triphenylmethane derivatives, methine and polymethine dyes, Prussian blue, titanium dioxide, manganese dioxide, and carbon black.

Hardeners are advantageously incorporated in the underlayer for the purpose of hardening the hydrophilic colloid that serves as a vehicle or binder. Preferred hardeners for this purpose include formaldehyde and bis(vinylsulfonyl)methane (BVSM) but many other suitable hardeners are also known to the art.

Another useful ingredient in the underlayer is a matting agent. Discrete solid particles of a matting agent, typically having an average particle size in the range of from 1 to 10 µm and preferably in the range of from 2 to 4 µm, can be effectively utilized in the underlayer. The matting agent is typically employed in an amount of from 0.02 to 1 part per part by weight of the hydrophilic colloid. Either organic or inorganic matting agents can be used. Examples of organic matting agents are particles, often in the form of beads, of polymers such as polymeric esters of acrylic and methacrylic acid, e.g., poly(methylmethacrylate), cellulose esters such as cellulose acetate propionate, cellulose ethers, ethyl cellulose, polyvinyl resins such as poly(vinyl acetate), and styrene polymers and copolymers. Examples of inorganic matting agents are particles of glass, silicon dioxide, titanium dioxide, magnesium oxide, aluminum oxide, barium sulfate, and calcium carbonate. Matting agents and the way they are used are further described in U.S. Patent Nos. 3,411,907 and 3,754,924.

An essential layer in the integral silver halide diffusion transfer lithographic printing plates of this invention is an image-receiving layer comprising a film-forming binder, physical development nuclei, and a polymer having epoxy functionality that enhances the wear resistance of the image-receiving layer.

A polymer latex as hereinabove described can be usefully employed as the film-forming binder in the image-receiving layer. A preferred polymer latex for use in the image-receiving layer is poly(3-methyl-1-vinyl imidazolinium methyl sulfate). Combinations of a hydrophilic colloid with a polymer latex can also be employed.

The use of physical development nuclei in diffusion transfer systems is well known in the art and any of the nuclei known to be useful for this purpose can be incorporated in the image-receiving layer of the printing plates of this invention. Useful physical development nuclei include metals such as antimony, bismuth, cadmium, cobalt, palladium, nickel, silver, lead and zinc and the sulfides thereof. Physical development nuclei that are preferred for use in the present invention are particles of nickel sulfide, especially in combination with silver iodide which acts as a stabilizer.

The polymer having epoxy functionality is used in this invention as a hardener and wear-resistance enhancer for the image-receiving layer. It is advantageously employed in an amount of from 1 to 100 milligrams per square meter (mg/m²) and more preferably from 10 to 50 milligrams per square meter.

Polymers having epoxy functionality that are useful in this invention can vary widely in structure and include homopolymers of epoxy monomers, copolymers formed by polymerizing two polymerizable monomers one or both of which provide epoxy functionality and interpolymers formed by polymerizing three or more polymerizable monomers at least one of which provides epoxy functionality.

By the term "epoxy functionality" is meant the presence of one or more pendant oxirane rings. Preferably, the polymer is comprised of recurring units of which at least 15 mole percent comprise a pendant oxirane ring.

Polymers having epoxy functionality which are especially preferred for use in this invention are comprised of recurring units represented by the formula: 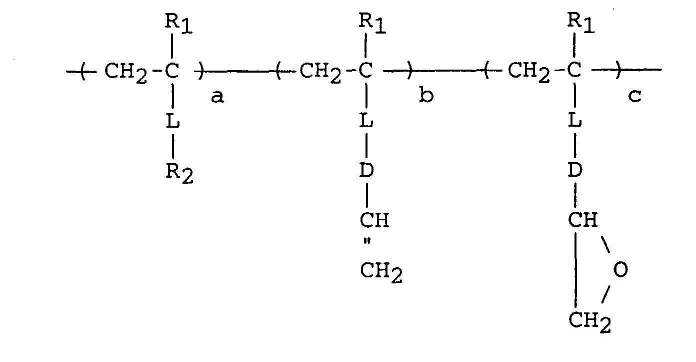 wherein:
R₁ is hydrogen or methyl,
R₂ is alkyl of 1 to 8 carbon atoms or cycloalkyl of 3 to 8 carbon atoms,
D is alkylene of 1 to 6 carbon atoms,
L is

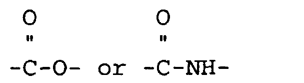

a = 30-75 mole %,
b = 0-10 mole %,
c = 15-70 mole %.

The above-described polymers having epoxy functionality are readily prepared by reacting a polymerizable epoxy compound with one or more polymerizable acrylic monomers.

Examples of suitable polymerizable acrylic monomers include:
ethyl acrylate
ethyl methacrylate
butyl acrylate
butyl methacrylate
cyclohexyl acrylate
cyclohexyl methacrylate
styrene
methyl acrylate
lauryl acrylate
lauryl methacrylate, and
allyl methacrylate.

Examples of suitable polymerizable epoxy monomers include:
glycidyl methacrylate
glycidyl acrylate, and
allyl glycidyl ether.

Specific examples of polymers having epoxy functionality that are preferred for use in this invention include:
poly(butyl acrylate-co-allyl methacrylate-co-glycidyl methacrylate)
poly(butyl methacrylate-co-allyl methacrylate-co-glycidyl methacrylate)
poly(butyl acrylate-co-glycidyl methacrylate)
poly(lauryl methacrylate-co-allyl methacrylate-co-glycidyl methacrylate)

As indicated hereinabove, polymers having hydroxy, carboxy or carbonyl functional groups can be included in the image-receiving layer. Hydroxylated polymers such as poly(vinyl alcohol) are particularly preferred. Examples of specific polymers that can be effectively employed in combination with the polyalkoxysilane include:
poly(vinyl alcohol)
hydroxyethyl cellulose
carboxymethyl cellulose
acrylamide-co-methylacrylate-co-hydroxyethyl methacrylate
poly(methyl methacrylate)
bisphenol-A polycarbonate
poly(vinyl acetate)
poly(vinyl pyrrolidone)
poly(acrylic acid)
poly(N,N-dimethyl acrylamide), and
poly(methyl methacrylate-co-methacrylic acid.

Polyalkoxysilanes useful in this invention as a component of the image-receiving layer include those represented by the formulae I or II as follows:

I Si(OR₁)₄

II R₂-Si(OR₃)₃

wherein R₁ and R₃ are individually unsubstituted or substituted alkyl containing 1 to 4 carbon atoms, such as methyl, ethyl, propyl and butyl, and R₂ is unsubstituted or substituted alkyl, such as alkyl containing 1 to 22 carbon atoms, such as methyl, ethyl, propyl, butyl, and n-octadecyl; or unsubstituted or substituted phenyl.

Specific examples of useful polyalkoxysilanes for the purpose of this invention include:

Si(OC₂H₅)₄

Si(OCH₃)₄

CH₃Si(OC₂H₅)₃

CH₃Si(OCH₃)₃

C₆H₅Si(OC₂H₅)₃

C₆H₅Si(OCH₃)₃

NH₂CH₂CH₂CH₂Si(OC₂H₅)₃

NH₂CH₂CH₂CH₂Si(OCH₃)₃

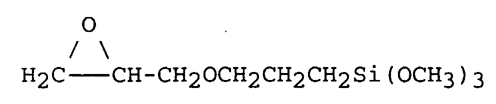

and

CH₃(CH₂)₁₇Si(OC₂H₅)₃.

The polyalkoxysilane is typically employed in this invention in an amount of from 10 to 500 cc/m², while the polymer having hydroxyl, carboxyl or carbonyl functional groups is typically employed in an amount of from 1 to 60 mg/m².

The combination of all three of a polymer having epoxy functionality, a polyalkoxysilane and a polymer having hydroxy, carboxy or carbonyl functional groups provides a highly effective hardening system which imparts excellent wear characteristics to the printing plate while retaining excellent image quality.

Other ingredients that can be usefully incorporated in the image-receiving layer include surfactants, plasticizers, solvents, and agents, such as hydrochloric acid, which function to catalyze the interaction between the polymers.

The printing plates of this invention can be provided with a backing layer that provides protection against unwanted curling. The backing layer is typically comprised of a hydrophilic colloid, such as gelatin, hardened with a suitable hardening agent such as formaldehyde.

In the printing plates of this invention, the thickness of the underlayer is typically 2 to 6 micrometers, the thickness of the image-forming layer is typically 0.5 to 4 micrometers, and the thickness of the image-receiving layer is typically 0.1 to 0.5 micrometers.

Processing solutions that are usefully employed with integral diffusion transfer printing plates are well known in the art. Such solutions typically include an activator solution, a stabilizer and a conditioner. The conditioner is often referred to as an "etch". The functions of these processing baths and suitable ingredients for use therein are described in Chapter 6 of Imaging Processes and Materials, Neblette's Eighth Edition, published by Van Nostrand, Reinhold, New York, N.Y., 1989, and in Chapter 8 of Modern Photographic Processing, Vol. 2, by Grant Haist, published by John Wiley and Sons, New York, N.Y., 1979. Patents relating to processing solutions that can be used with integral diffusion transfer printing plates include U.S. Patents 3,776,728, 4,230,792, 4,297,429, 4,320,613, 4,436,805, 4,454,216, 5,068,164 and 5,258,258.

The invention is further illustrated by the following examples of its practice.

A poly(ethylene terephthalate) film support with a thickness of 0.1 millimeters was coated, in order, with an underlayer, an image-forming layer and an image-receiving layer to prepare a lithographic printing plate in accordance with this invention. The underlayer was comprised of the following ingredients in the amount indicated: gelatin (2.33 g/m²), carbon black (0.104 g/m²), silicon dioxide (0.6 g/m²), hydroquinone (0.594 g/m²), 1-phenyl-3-pyrazolidone (0.003 g/m²), sodium formaldehyde bisulfite (0.198 g/m²) and BVSM (0.20 g/m²). The gelatin serves as the vehicle, the carbon black as the antihalation agent, the silicon dioxide as a matting agent, the hydroquinone as the primary developing agent, the 1-phenyl-3-pyrazolidone as the auxiliary developing agent, the sodium formaldehyde bisulfite as a stabilizer for the hydroquinone, and the BVSM as a hardener for the gelatin. The image-forming layer contained gelatin in an amount of 1.43 g/m² as the vehicle, iridium-doped silver chloride grains with a mean grain size of 0.38 micrometers in an amount of 1.5 g Ag/m² as the radiation-sensitive agent, 4-hydroxy-6-methyl-1,3,3a,7-tetraazaindene in an amount of 3 grams per silver mole as the antifoggant, anhydro-9-ethyl-3,3'-di-(3-sulfopropyl)-4,5,4',5'-dibenzothiacarbocyanine hydroxide-Na salt in an amount of 0.0017 g/m² as the sensitizing dye, and a surfactant in an amount of 0.00643 g/m².

In a lithographic printing plate referred to hereinafter as Control 1, the image-receiving layer was comprised of the following ingredients in the amount indicated: poly(3-methyl-1-vinyl imidazolinium methyl sulfate ) (4.00 mg/m²), nickel sulfide (0.12 mg/m²), silver iodide (0.20 mg/m²), surfactant (6.00 mg/m²), ethyl alcohol (0.004 cc/m²) and ethylene glycol (0.0035 cc/m²). The poly(3-methyl-1-vinyl imidazolinium methyl sulfate) serves as the vehicle, the nickel sulfide as the physical development nuclei, the silver iodide as a stabilizer for the nuclei, the ethyl alcohol as a solvent, and the ethylene glycol as a plasticizer.

A second lithographic printing plate, referred to herein as Control 2, was the same as Control 1 except that the image-receiving layer additionally contained 40 cc/m² of tetraethyl orthosilicate (TEOS). A third lithographic printing plate, referred to herein as control 3, was the same as Control 2 except that the image-receiving layer additionally contained 4 mg/m² of polyvinyl alcohol (PVA).

In Example 1 of this invention, the printing plate was the same as Control 1 except that the image-receiving layer additionally contained 32 mg/m² of poly(butyl acrylate-co-allyl methacrylate-co-glycidyl methacrylate). This epoxy polymer is referred to hereinafter by the designation GM. In Example 2 of this invention, the printing plate was the same as Example 1 except that the image-receiving layer additionally contained 40 cc/m² of TEOS and 4 mg/m²of PVA.

The integral diffusion transfer lithographic printing plates described above were processed with a conventional activator solution, stabilizing solution and conditioning solution and run on a printing press to evaluate run length. As the term is used herein, "run length" refers to the number of printed impressions obtained before a 20% dot is reduced to a 12% dot.

The results obtained in the evaluation of run length are summarized in Table I below.

**Table I**

| Printing Plate | TEOS (cc/m²) | PVA (mg/m²) | GM (mg/m²) | Run Length |
|---|---|---|---|---|
| Control 1 | 0 | 0 | 0 | 1000 |
| Control 2 | 40 | 0 | 0 | 10000 |
| Control 3 | 40 | 4 | 0 | 15000 |
| Example 1 | 0 | 0 | 32 | 20000 |
| Example 2 | 40 | 4 | 32 | 24000 |

As shown by the data in Table I, a printing plate which contained none of the three polymers described herein had a run length of only 1000 impressions. Adding TEOS in Control 2, increased the run length to 10000 impressions. Adding both TEOS and PVA in Control 3 increased the run length to 15000 impressions. This was not as good as with the plate of Example 1 in which only the GM polymer was added and the run length was 20000 impressions. The best results, a run length of 24000 impressions, were obtained in Example 2 which employed all three of TEOS, PVA and the GM polymer.

While Applicants do not wish to be bound by any theoretical explanation of the manner in which their invention functions, it is believed that the very small silver halide grains are able to quickly form a complex with the silver halide solvent present in the activator solution and to diffuse through the image-forming layer and to the surface of the image-receiving layer at such a rapid rate that a very densely packed silver image of a morphology which promotes long run life is formed. Furthermore, it is believed that the polymer having epoxy functionality forms a cross-linked network which imparts excellent wearing characteristics to the printing plate. In the optimum embodiment of Example 2, it is believed that the TEOS is hydrolyzed in situ to polysilicic acid and that the polysilicic acid bonds with the functional groups of both the PVA and the GM polymer.

## Claims

1. An integral silver halide diffusion transfer lithographic printing plate, said printing plate comprising a support having, in order, on one side thereof:
(1) an image-forming layer comprising a film-forming binder and silver halide grains; and
(2) an image-receiving layer comprising a film-forming binder and physical development nuclei; characterized in that said image-receiving layer additionally contains a polymer having epoxy functionality that enhances the wear-resistance of said image-receiving layer.

2. A printing plate as claimed in claim 1, wherein said silver halide grains are at least 80 mole percent silver chloride.

3. A printing plate as claimed in claims 1 or 2, wherein said silver halide grains have a mean grain size of less than 0.5 micrometers.

4. A printing plate as claimed in any of claims 1 to 3, wherein said polymer having epoxy functionality is comprised of recurring units of which at least 15 mole percent comprise a pendant oxirane ring.

5. A printing plate as claimed in any of claims 1 to 3, wherein said polymer having epoxy functionality is comprised of recurring units represented by the formula: 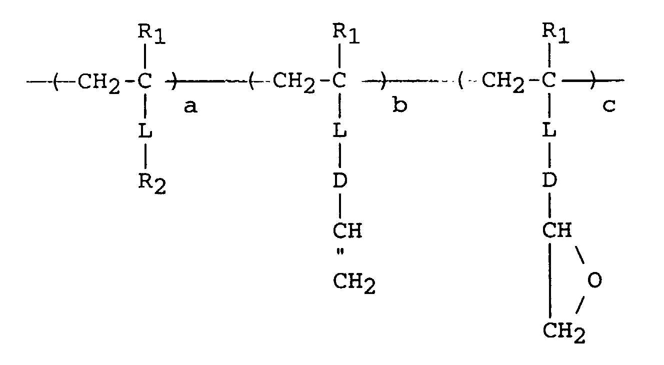 wherein:
R₁ is hydrogen or methyl,
R₂ is alkyl of 1 to 8 carbon atoms or cycloalkyl of 3 to 8 carbon atoms,
D is alkylene of 1 to 6 carbon atoms,
L is 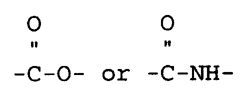
a = 30-75 mole %,
b = 0-10 mole %,
c = 15-70 mole %.

6. A printing plate as claimed in any of claims 1 to 5, wherein said polymer having epoxy functionality is poly(butyl acrylate-co-allyl methacrylate-co-glycidyl methacrylate).

7. A printing plate as claimed in any of claims 1 to 6, whereas said image-receiving layer additionally comprises a polyalkoxysilane and a polymer having hydroxy, carboxy or carbonyl functional groups.

8. A printing plate as claimed in claim 7, wherein said polymer having hydroxy, carboxy or carbonyl functional groups is poly(vinyl alcohol).

9. A printing plate as claimed in claims 7 or 8, wherein said polyalkoxysilane is represented by formula I or II as follows:
I Si(OR₁)₄
II R₂-Si(OR₃)₃
wherein R₁ and R₃ are individually unsubstituted or substituted alkyl containing 1 to 4 carbon atoms and R₂ is unsubstituted or substituted alkyl or phenyl.

10. A printing plate as claimed in claims 7 or 8, wherein said polyalkoxysilane is selected from the group consisting of:
Si(OC₂H₅)₄
Si(OCH₃)₄
CH₃Si(OC₂H₅)₃
CH₃Si(OCH₃)₃
C₆H₅Si(OC₂H₅)₃
C₆H₅Si(OCH₃)₃
NH₂CH₂CH₂CH₂Si(OC₂H₅)₃
NH₂CH₂CH₂CH₂Si(OCH₃)₃ 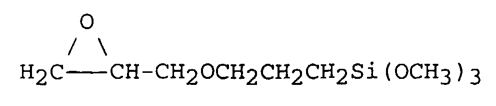
and
CH₃(CH₂)₁₇Si(OC₂H₅)₃.

## Patentansprüche

1. Als Einheit ausgebildete lithographische Druckplatte für die Silberhalogenid-Diffusionsübertragung, wobei die Druckplatte einen Träger umfaßt, der der Reihe nach auf einer Seite desselben aufweist:
(1) eine Bild-erzeugende Schicht, die ein Film-bildendes Bindemittel und Silberhalogenidkörner umfaßt; und
(2) eine Bildempfangsschicht, die ein Film-bildendes Bindemittel und physikalische Entwicklungskristallisationskeime umfaßt;
dadurch gekennzeichnet, daß die Bildempfangsschicht zusätzlich ein Polymer mit Epoxy-Funktionalität enthält, das die Verschleißbeständigkeit der Bildempfangsschicht vergrößert.

2. Druckplatte nach Anspruch 1, bei der die Silberhalogenidkörner mindestens zu 80 Molprozent Silberchlorid sind.

3. Druckplatte nach Anspruch 1 oder 2, bei der die Silberhalogenidkörner eine mittlere Korngröße von weniger als 0,5 Mikrometer aufweisen.

4. Druckplatte nach irgendeinem der Ansprüche 1 bis 3, bei der das Polymer mit Epoxy-Funktionalität wiederkehrende Einheiten umfaßt, von denen mindestens 15 Molprozent einen seitenständigen Oxiranring umfassen.

5. Druckplatte nach irgendeinem der Ansprüche 1 bis 3, bei der das Polymer mit Epoxy-Funktionalität wiederkehrende Einheiten umfaßt, die durch die Formel: 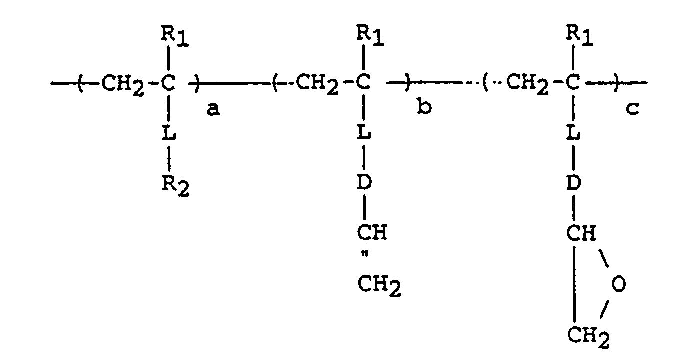 dargestellt werden, in der:
R₁ Wasserstoff oder Methyl ist,
R₂ Alkyl mit 1 bis 8 Kohlenstoffatomen oder Cycloalkyl mit 3 bis 8 Kohlenstoffatomen ist,
D Alkylen mit 1 bis 6 Kohlenstoffatomen ist,
L für 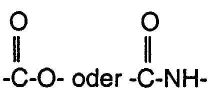 steht,
a = 30 - 75 Mol-%,
b = 0 - 10 Mol-%,
c = 15 - 70 Mol-%.

6. Druckplatte nach irgendeinem der Ansprüche 1 bis 5, bei der das Polymer mit Epoxy-Funktionalität Poly(butylacrylat-co-allylmethacrylat-co-glycidylmethacrylat) ist.

7. Druckplatte nach irgendeinem der Ansprüche 1 bis 6, bei der die Bildempfangsschicht zusätzlich ein Polyalkoxysilan und ein Polymer mit funktionellen Hydroxy-, Carboxy- oder Carbonylgruppen umfaßt.

8. Druckplatte nach Anspruch 7, bei der das Polymer, das funktionelle Hydroxy-, Carboxy- oder Carbonylgruppen aufweist, Poly(vinylalkohol) ist.

9. Druckplatte nach Anspruch 7 oder 8, bei der das Polyalkoxysilan durch die Formel I oder II wie folgt dargestellt wird:
I Si(OR₁)₄
II R₂-Si(OR₃)₃
worin R₁ und R₃ einzeln unsubstituiertes oder substituiertes Alkyl, das 1 bis 4 Kohlenstoffatome enthält, sind und R₂ unsubstituiertes oder substituiertes Alkyl oder Phenyl ist.

10. Druckplatte nach Anspruch 7 oder 8, bei der das Polyalkoxysilan aus der Gruppe ausgewählt ist, die besteht aus:
Si(OC₂H₅)₄
Si(OCH₃)₄
CH₃Si(OC₂H₅)₃
CH₃Si(OCH₃)₃
C₆H₅Si(OC₂H₅)₃
C₆H₅Si(OCH₃)₃
NH₂CH₂CH₂CH₂Si(OC₂H₅)₃
NH₂CH₂CH₂CH₂Si(OCH₃)₃ 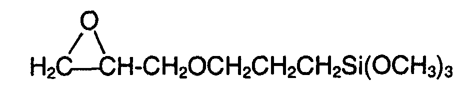
und
CH₃(CH₂)₁₇Si(OC₂H₅)₃.

## Revendications

1. Plaque d'impression lithographique intégrale aux halogénures d'argent pour transfert par diffusion, ladite plaque d'impression comprenant un support dont l'une des faces est recouverte, dans l'ordre, par :
(1) une couche formatrice d'image comprenant un liant filmogène et des grains d'halogénures d'argent ; et
(2) une couche réceptrice d'image comprenant un liant filmogène et des germes de développement physique ;
caractérisée en ce que ladite couche réceptrice d'image contient aussi un polymère comprenant une fonction époxy qui améliore la résistance à l'usure de ladite couche réceptrice d'image.

2. Plaque d'impression selon la revendication 1, dans laquelle lesdits grains d'halogénures d'argent comprennent au moins 80 pourcent en moles de chlorure d'argent.

3. Plaque d'impression selon les revendications 1 ou 2, dans laquelle lesdits grains d'halogénures d'argent ont une granulométrie moyenne inférieure à 0,5 micromètre.

4. Plaque d'impression selon l'une quelconque des revendications 1 à 3, dans laquelle ledit polymère comprenant une fonction époxy est constitué de motifs dont au moins 15 pourcent en moles comprennent un noyau oxirane latéral.

5. Plaque d'impression selon l'une quelconque des revendications 1 à 3, dans laquelle ledit polymère comprenant une fonction époxy est constitué de motifs représentés par la formule : 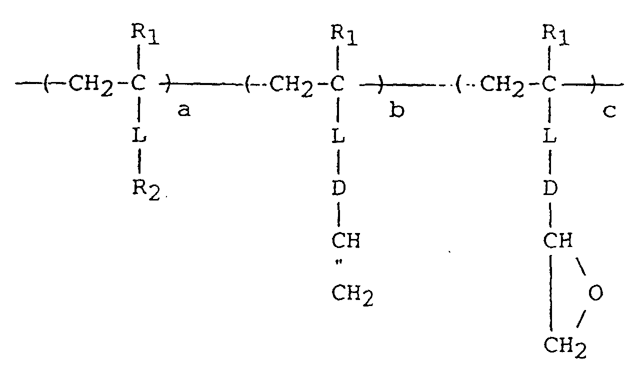 où :
R₁ est un hydrogène ou un groupe méthyle,
R₂ est un groupe alkyle ayant 1 à 8 atomes de carbone ou un groupe cycloalkyle ayant 3 à 8 atomes de carbone,
D est un groupe alkylène ayant 1 à 6 atomes de carbone,
L is 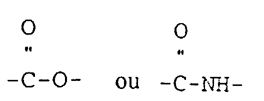
a = 30-75 % en moles
b = 0-10 % en moles,
c = 15-70 % en moles.

6. Plaque d'impression selon l'une quelconque des revendications 1 à 5, dans laquelle ledit polymère comprenant une fonction époxy est un copolymère d'acrylate de butyle, de méthacrylate d'allyle et de méthacrylate de glycidyle.

7. Plaque d'impression selon l'une quelconque des revendications 1 à 6, dans laquelle ladite couche réceptrice d'image comprend aussi un polyalkoxysilane et un polymère comprenant des groupes fonctionnels hydroxy, carboxy ou carbonyle.

8. Plaque d'impression selon la revendication 7, dans laquelle ledit polymère comprenant des groupes fonctionnels hydroxy, carboxy ou carbonyle est un alcool polyvinylique.

9. Plaque d'impression selon les revendications 7 ou 8, dans laquelle ledit polyalkoxysilane est représenté par la formule I ou Il suivante :
I Si(OR₁)₄
II R₂-Si(OR₃)₃
où R₁ et R₃ représentent individuellement un groupe alkyle substitué ou non substitué contenant 1 à 4 atomes de carbone et R₂ représente un groupe alkyle ou phényle substitué ou non substitué.

10. Plaque d'impression selon les revendications 7 ou 8, dans laquelle ledit polyalkoxysilane est choisi dans le groupe constitué de :
Si(OC₂H₅)₄
Si(OCH₃)₄
CH₃Si(OC₂H₅)₃
CH₃Si(OCH₃)₃
C₆H₅Si(OC₂H₅)₃
C₆H₅Si(OCH₃)₃
NH₂CH₂CH₂CH₂Si(OC₂H₅)₃
NH₂CH₂CH₂CH₂Si(OCH₃)₃ 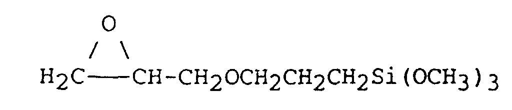
et
CH₃(CH₂)₁₇Si(OC₂H₅)₃.
